# EUROPÄISCHE PATENTSCHRIFT

(11) **EP 3 094 763 B1**
(45) Veröffentlichungstag und Bekanntmachung des Hinweises auf die Patenterteilung: **06.03.2019**
(21) Anmeldenummer: 14808654.9
(22) Anmeldetag: 08.12.2014
(51) Int. Cl.: C23C 28/00, C23C 30/00, C23C 14/06, C23C 16/32, F16J 9/26

(54) **GLEITELEMENT, INSBESONDERE KOLBENRING**
SLIDING ELEMENT, IN PARTICULAR PISTON RING
ÉLÉMENT COULISSANT, EN PARTICULIER SEGMENT DE PISTON

(30) Priorität: 15.01.2014 DE 102014200607
(43) Veröffentlichungstag der Anmeldung: 23.11.2016
(73) Patentinhaber: Federal-Mogul Burscheid GmbH, 51399 Burscheid (DE)
(72) Erfinder: KENNEDY, Marcus, 40477 Düsseldorf (DE); ZINNABOLD, Michael, 51399 Burscheid (DE); ESSER, Peter, 51515 Kürten (DE)
(74) Vertreter: Hoffmann Eitle
(86) Internationale Anmeldenummer: PCT/EP2014/076866
(87) Internationale Veröffentlichungsnummer: WO 2015/106884

(56) Entgegenhaltungen:
- WO-A1-2012/100847
- US-A1- 2012 187 435
- WOS P ET AL: "Effect of Initial Cylinder Liner Honing Surface Roughness on Aircraft Piston Engine Performances", TRIBOLOGY LETTERS, Bd. 41, Nr. 3, 6. Januar 2011 (2011-01-06) , Seiten 555-567, XP019883784, KLUWER ACADEMIC PUBLISHERS-PLENUM PUBLISHERS [NL] ISSN: 1573-2711, DOI: 10.1007/S11249-010-9733-Y
- KUZINOVSKI M ET AL: "Effect of sampling parameters upon change of hybrid parameters values of the roughness profile", JOURNAL OF PRODUCTION ENGINEERING, Bd. 12, Nr. 1, Dezember 2009 (2009-12), Seiten 23-28, XP055167058, Faculty of Technical Sciences - Department for Production Engineering, Novi Sad [RS] ISSN: 1821-4932

## Beschreibung

### TECHNISCHES GEBIET

Die Erfindung betrifft ein Gleitelement und insbesondere einen Kolbenring.

Für Gleitelemente im Allgemeinen und Kolbenringe im Besonderen ist es ein wesentliches Kriterium, in welchem Umfang im Betrieb Reibungsverluste auftreten. Bei Verbrennungsmotoren, in denen Kolbenringe eingesetzt werden, fordert sowohl der Markt als auch die Gesetzgeber eine Senkung des Kraftstoffverbrauchs und damit der Kohlendioxidemissionen. Nachdem die Kolbenringe für etwa ein Viertel der mechanischen Reibleistungsverluste damit für etwa 4 % des Kraftstoffverbrauchs verantwortlich sind, beschäftigt sich die Forschung umfangreich mit Maßnahmen, um diese Reibleistungsverluste durch Kolbenringe und Gleitelemente im Allgemeinen zu verringern.

### STAND DER TECHNIK

Hierbei werden, wie beispielsweise in der DE 44 19 713 A1 beschrieben, zum einen Hartmetallbeschichtungen eingesetzt, die üblicherweise mittels PVD-Verfahren hergestellt werden. Zum anderen werden amorphe DLC-Beschichtungen verwendet, die jedoch üblicherweise nur mit einer Schichtdicke von wenigen µm aufgetragen werden können. Eine weitere Herausforderung besteht darin, die extrem harten DLC-Beschichtungen mit einer ausreichend geringen Rauheit zu versehen, um Beschädigungen der Zylinderlaufflächen oder -buchsen und Verschleiß zu vermeiden. Aus der DE 10 2008 022 039 A1 und der EP 0 724 023 A1 sind verschiedene hierfür geeignete taC-Schichtsysteme bekannt.

WO 2012/100847 A offenbart ein Gleitelement in Form eines Kolbenrings aus Gusseisen oder Stahl, der mit einer metallhaltigen Haftschicht und einer DLC-Schicht des Typs ta-C mit einer Dicke von mindestens 10 µm beschichtet ist. Die ta-C-Schicht ist im wesentlichen sauerstoff- und/oder wasserstofffrei (< 0,5 at.%). Die DLC-Schicht weist bevorzugt im beschichteten Zustand eine Rauhtiefe von R_{z} < 6 µm sowie im endbearbeiteten Zustand eine Rauhtiefe von R_{z} < 2 µm, insbesondere < 1 µm, sowie eine reduzierte Spitzentiefe von Rₚₖ < 0,3 µm, insbesondere < 0,1 µm auf. Durch eine gezielte Reduzierung des sp³-Anteils in den randnahen äußeren 1 µm bis 3 µm der Schicht kommt es zu einer weiteren Reduzierung der Reibung im Einlauf sowie der Einlaufzeit selbst.

### DARSTELLUNG DER ERFINDUNG

Vor diesem Hintergrund liegt der Erfindung die Aufgabe zugrunde, ein Gleitelement und insbesondere einen Kolbenring zu schaffen, der im Hinblick auf die Kombination von möglichst geringem Verschleiß und möglichst geringer Reibung, auch beim Starten der Gleitbewegung, insbesondere des Motors, verbessert ist.

Die Lösung dieser Aufgabe erfolgt durch das im Anspruch 1 beschriebene Gleitelement. Demzufolge weist dieses, bei dem es sich bevorzugt um einen Kolbenring handelt, eine Lauffläche auf, die mit einer kohlenstoffbasierten Beschichtung versehen ist und zumindest abschnittsweise eine Rauheit mit einem quadratischen Mittelwert der Profilsteigung R_{Δq} gemäß DIN EN ISO 4287 von 0,05, bevorzugt 0,08, bis 0,11, bevorzugt bis 0,1 aufweist. Bei umfangreichen Untersuchungen hat sich herausgestellt, dass die vergleichsweise geringen Reibleistungsverluste bei der Verwendung von kohlenstoffbasierten Beschichtungen darauf beruhen, dass, thermisch und/oder mechanisch induziert, sp3-hybridisierte Kohlenstoffatome in sp2-hybridisierte Kohlenstoffatome umgewandelt werden. Hierdurch entsteht eine sehr dünne und verglichen mit der darunterliegenden DLC-Schicht weichere Topschicht, die reibungsreduzierend wirkt.

Diese gewünschte Umwandlung wird gemäß der Erfindung insbesondere dadurch begünstigt, dass die mittlere Profilsteigung des Rauheitsprofils oberhalb des Minimalwertes von 0,05 liegt oder allenfalls diesen Wert beträgt. Der für die Erfindung herangezogene R_{Δq}-Wert ist nämlich durch die genannte Norm dahingehend definiert, dass es sich um den quadratischen Mittelwert der Profilsteigung, also die mittlere quadratische Neigung des gefilterten Profils, bezogen auf die mittlere Linie handelt. Ein niedriger Wert bedeutet somit ein vergleichsweises "flaches" Profil, und ein hoher Wert ein vergleichsweise "steiles", Profil. Bei Untersuchungen hat sich herausgestellt, dass unterhalb eines R_{Δq}-Wertes von 0,05 der Reibkoeffizient größer als 0,035 wird, was in einer nicht wünschenswerten Größenordnung liegt. Durch R_{Δq}-Werte größer oder allenfalls gleich 0,05 können somit äußerst geringe Reibungskoeffizienten gewährleistet werden, was dadurch erklärt werden kann, wenngleich die Erfindung nicht hierauf beschränkt sein soll, dass die Profilsteigung ausreichend steil ist, um zahlreiche Umwandlungen von sp3- zu sp2-hybridisierten Kohlenstoffatomen zu bewirken und den Reibkoeffizienten damit in der gewünschten Weise positiv zu beeinflussen.

Gleichzeitig wurde bei R_{Δq}-Werten von 0,1 oder mehr und insbesondere von 0,11 oder mehr festgestellt, dass der Verschleiß in unerwünschter Weise zunimmt, nämlich in der Größenordnung von mehr als 3 µm liegt. Die Erklärung hierfür, auf die die Erfindung ebenfalls nicht beschränkt sein soll, ist darin zu suchen, dass bei einer vergleichsweise "steilen" Rauheitsprofilsteigung die Flächenpressung erhöht ist, was den Verschleiß fördert. Die Erfindung schafft somit einen vorteilhaften Ausgleich zwischen günstigen Verschleißwerten einerseits und geringen Reibkoeffizienten andererseits. Zu den gewünschten R_{Δq}-Werten sei erwähnt, dass sie durch geeignete Beschichtungs- und insbesondere Bearbeitungsprozesse eingestellt werden können. Die R_{Δq}-Werte werden durch eine geeignete Kombination aus Beschichtungs- und Glättungsverfahren sichergestellt. Bei dem Beschichtungsverfahren handelt es sich um einen PA-CVD oder PVD Prozess. Diese Prozesse erlauben eine gezielte Einstellung der mechanischen Eigenschaften, die zum Erreichen der notwendigen Rauheitswerte benötigt werden. Die Einstellgröße ist die Energie der abgeschiedenen Kohlenstoffionen. Diese Energie kann durch Änderungen des Verdampferstroms, von Magnetfeldern sowie der BIAS-Versorgung beeinflusst werden. Der Glättungsprozess ist eine Feinstbearbeitung mit definierten diamanthaltigen Glättungswerkzeugen, wobei die Diamantmorphologie, die Verteilung der gebundenen Diamanten sowie das Werkzeug selbst in geeigneter Weise angepasst sind.

Die Erfindung beruht maßgeblich auf den oben genannten Erkenntnissen betreffend den Bereich für den R_{Δq}-Wert, während sich für andere Rauheitsparameter herausgestellt hat, dass sie für die Eingrenzung auf bestimmte Bereiche, um einen vorteilhaften Ausgleich zwischen Verschleiß- und Reibungswerten zu erhalten, nicht geeignet sind. Zu den vorangehend erwähnten Messwerten ist zu sagen, dass diese, wie nachfolgend unter Bezugnahme auf die Tabelle detailliert, unter Mischreibungsbedingungen ermittelt wurden, wie sie in Verbrennungsmotoren im tatsächlichen Betrieb relevant sind. Hierbei erreicht die Schmierfilmdicke im Wesentlichen die Gesamtrautiefe von Grund- und Gegenkörper, also beispielsweise von Kolbenring und Zylinderlaufbuchse, so dass Belastungen durch den direkten Kontakt der Rauheitshügel auf die Laufpartner übertragen werden können. In dieser Situation werden die Reibungsverhältnisse durch den Festkörperkontakt beeinflusst, was möglichst glatte Oberflächen erfordert. Sogar kleinste Unebenheiten können zu Scherkräften führen, welche insbesondere die kohlenstoffbasierte Beschichtung schädigen und zur Schichtablösung führen können.

Bevorzugte Weiterbildungen des erfindungsgemäßen Gleitelements sind in den weiteren Ansprüchen beschrieben.

Nachdem der Gleitkontakt zwischen beispielweise einem Kolbenring und einer Zylinderlaufbuchse insbesondere im Bereich einer Balligkeit, also einer konvex gekrümmten Lauffläche des Kolbenrings erfolgt, wird bevorzugt, dass die erfindungsgemäße Rauheit zumindest im Bereich einer derartigen Balligkeit ausgebildet ist.

Ferner hat sich herausgestellt, dass die beschriebenen R_{Δq}-Werte in axialer Richtung des Kolbenrings auf 10-90%, bevorzugt 25-75% der Lauffläche vorhanden sein sollten.

Für die Beschichtung wird eine kohlenstoffbasierte Beschichtung vom Typ ta-C bevorzugt, um die beschriebenen Effekte besonders gut nutzen zu können.

Für die Schichtdicke der kohlenstoffbasierten Beschichtung hat sich ein Bereich von 0,5, bevorzugt 10 bis 30 µm als besonders günstig herausgestellt. Ein weiterer bevorzugter Schichtdickenbereich sind 0,5 bis 10 µm.

Dies gilt in gleicher Weise für einen sp3-, also einen in sp2 umwandelbaren Anteil von hybridisierten Kohlenstoffatomen von mindestens 40 At%.

Bei den Versuchen konnte ferner festgestellt werden, dass die konsistente Korrelation zwischen den R_{Δq}-Werten und Verschleiß sowie Reibungskoeffizienten insbesondere für Werte des E-Moduls von 180 bis 260 GPa und Härtewerte von 1600 bis 2800 HV0,02 festgestellt wurden. Beide Parameter werden nach der Oliver & Pfarr Methode (O&P) gemessen.

Im Hinblick auf das sp3/sp2-Verhältnis werden 0,3 bis 1,2 bevorzugt.

Für eine sichere Haftung der kohlenstoffbasierten Beschichtung auf einem Substrat wird zwischen der kohlenstoffbasierten Beschichtung und dem Substrat eine metallhaltige Haftschicht, mit Chrom und/oder Titan bevorzugt.

Für die Dicke der Haftschicht hat sich ein Bereich von 0,05 µm bis 1,0 µm als günstig erwiesen.

Die beschriebenen, günstigen Auswirkungen auf sowohl den Verschleiß als auch den Reibungskoeffizienten konnten insbesondere für einen Kohlenstoffanteil der Beschichtung festgestellt werden, der über die gesamte Schichtdicke mehr als 99 Prozent beträgt.

Schließlich wird für den Kolbenring bevorzugt, dass er aus Gusseisen oder Stahl besteht.

### BEISPIELE

Erfindungsgemäße Beispiele in Form von realen Kolbenringsegmenten auf einem realen, gehonten Grauguss-Zylinderlaufbahnsegment in einem Schwingreibverschleiß-Messsystem wurden unter Mischreibungsbedingungen bei definierten Druck- und Temperaturbedingungen getestet. In der nachfolgenden Tabelle finden sich die jeweiligen R_{Δq}-Werte, hier mit Rdq bezeichnet, mit dem jeweiligen Ringverschleiß und Reibkoeffizient. Wie insbesondere aus der Gesamtbewertung hervorgeht, sind sowohl der Ringverschleiß als auch der Reibkoeffizient lediglich im Bereich 0,05 bis 0,11 des R_{Δq}-Wertes in Ordnung ("i.O."). Das E-Modul und die Härte lagen in den vorangehend genannten Bereichen, für die eine besonders konsistente Korrelation zwischen den R_{Δq}-Werten und Ringverschleiß sowie Reibkoeffizient festgestellt werden konnte.

| **Rdq** | Rz | Rk | Rpk | **Ringverschleiss** | **Reibkoeffizient µ** | Bewertung Ringverschleiss | Bewertung Reibkoeffizient | **Gesamt** |
|---|---|---|---|---|---|---|---|---|
| | (µm) | (µm) | (µm) | **(µm)** | **()** | | | |
| **0,02** | 0,2 | 0,06 | 0,02 | **1,0** | **0,049** | i.O. | n.i.O. | **n.i.O.** |
| **0,02** | 0,3 | 0,07 | 0,02 | **0,5** | **0,048** | i.O. | n.i.O. | **n.i.O.** |
| **0,02** | 0,23 | 0,1 | 0,02 | **1,0** | **0,052** | i.O. | n.i.O. | **n.i.O.** |
| **0,02** | 0,18 | 0,07 | 0,02 | **1,5** | **0,044** | i.O. | n.i.O. | **n.i.O.** |
| **0,02** | 0,22 | 0,11 | 0,03 | **0,5** | **0,043** | i.O. | n.i.O. | **n.i.O.** |
| **0,04** | 0,56 | 0,15 | 0,02 | **0,5** | **0,05** | i.O. | n.i.O. | **n.i.O.** |
| **0,06** | 0,45 | 0,18 | 0,08 | **1,0** | **0,024** | i.O. | i.O. | **i.O.** |
| **0,07** | 0,88 | 0,24 | 0,13 | **2,5** | **0,027** | i.O. | i.O. | **i.O.** |
| **0,08** | 0,94 | 0,25 | 0,15 | **2,0** | **0,032** | i.O. | i.O. | **i.O.** |
| **0,08** | 1,07 | 0,18 | 0,19 | **1,0** | **0,027** | i.O. | i.O. | **i.O.** |
| **0,09** | 1,15 | 0,24 | 0,16 | **1,5** | **0,03** | i.O. | i.O. | **i.O.** |
| **0,09** | 1,06 | 0,26 | 0,16 | **1,5** | **0,03** | i.O. | i.O. | **i.O.** |
| **0,1** | 1,11 | 0,31 | 0,18 | **3,0** | **0,033** | i.O. | i.O. | **i.O.** |
| **0,12** | 1,06 | 0,32 | 0,18 | **11,0** | **0,012** | n.i.O. | i.O. | **n.i.O.** |
| **0,14** | 1,1 | 0,43 | 0,17 | **6,5** | **0,015** | n.i.O. | i.O. | **n.i.O.** |
| **0,15** | 1,08 | 0,45 | 0,18 | **5,5** | **0,009** | n.i.O. | i.O. | **n.i.O.** |

## Patentansprüche

1. Gleitelement, insbesondere Kolbenring, mit zumindest einer Lauffläche, die mit einer kohlenstoffbasierten Beschichtung versehen ist und zumindest abschnittsweise eine Rauheit mit einem quadratischen Mittelwert der Profilsteigung R_{Δq} gemäß DIN EN ISO 4287 von 0,05, bevorzugt 0,08, bis 0,11, bevorzugt bis 0,1 aufweist.

2. Gleitelement nach Anspruch 1, **dadurch gekennzeichnet, dass** der quadratische Mittelwert der Profilsteigung R_{Δq} von 0,05 bis 0,1 zumindest im Bereich einer Balligkeit des Gleitelements ausgebildet ist.

3. Gleitelement nach Anspruch 1 oder 2, **dadurch gekennzeichnet, dass** der quadratische Mittelwert der Profilsteigung R_{Δq} von 0,05 bis 0,1 in axialer Richtung über 10-90%, bevorzugt 25-75% der Lauffläche ausgebildet ist.

4. Gleitelement nach zumindest einem der vorangehenden Ansprüche, **dadurch gekennzeichnet, dass** die kohlenstoffbasierte Beschichtung vom Typ ta-C ist.

5. Gleitelement nach zumindest einem der vorangehenden Ansprüche, **dadurch gekennzeichnet, dass** die Schichtdicke der Beschichtung 0,5, bevorzugt 10 bis 30 µm beträgt.

6. Gleitelement nach zumindest einem der vorangehenden Ansprüche, **dadurch gekennzeichnet, dass** die kohlenstoffbasierte Beschichtung einen sp3-Anteil von hybridisierten Kohlenstoffatomen von mindestens 40 At% aufweist.

7. Gleitelement nach zumindest einem der vorangehenden Ansprüche, **dadurch gekennzeichnet, dass** die kohlenstoffbasierte Beschichtung ein E-Modul von 180 bis 260 GPa und/oder eine Härte von 1600 bis 2800 HV0,02 aufweist.

8. Gleitelement nach zumindest einem der vorangehenden Ansprüche, **dadurch gekennzeichnet, dass** die kohlenstoffbasierte Beschichtung Sauerstoff und/oder Wasserstoff mit einem Anteil von jeweils weniger als 0,5 At% aufweist.

9. Gleitelement nach zumindest einem der vorangehenden Ansprüche, **dadurch gekennzeichnet, dass** die kohlenstoffbasierte Beschichtung ein sp3/sp2-Verhältnis von 0,3 bis 1,2 aufweist.

10. Gleitelement nach zumindest einem der vorangehenden Ansprüche, **dadurch gekennzeichnet, dass** zwischen der kohlenstoffbasierten Beschichtung und einem Substrat eine metallhaltige Haftschicht mit Chrom und/oder Titan vorgesehen ist.

11. Gleitelement nach Anspruch 10, **dadurch gekennzeichnet, dass** die Haftschicht eine Dicke von 0,05 bis 1,0 µm aufweist.

12. Gleitelement nach zumindest einem der vorangehenden Ansprüche, **dadurch gekennzeichnet, dass** der Kohlenstoffanteil in der kohlenstoffbasierten Beschichtung über die gesamte Schichtdicke mehr als 99 % beträgt.

13. Gleitelement nach zumindest einem der vorangehenden Ansprüche, **dadurch gekennzeichnet, dass** das Gleitelement ein Kolbenring ist, der aus Gusseisen oder Stahl besteht.

## Claims

1. Sliding element, in particular a piston ring, with at least one running surface which is provided with a carbon-based coating and at least in sections exhibits a roughness with a root mean square of the profile slope R_{Δq} according to DIN EN ISO 4287 of 0.05, preferably 0.08, to 0.11, preferably to 0.1.

2. Sliding element according to claim 1, **characterised in that** the root mean square of the profile slope R_{Δq} of 0.05 to 0.1 is provided at least in the region of a convexity of the sliding element.

3. Sliding element according to claim 1 or 2, **characterised in that** the root mean square of the profile slope R^{Δq} of 0.05 to 0.1 is provided, in an axial direction, over 10-90%, preferably 25-75% of the running surface.

4. Sliding element according to at least one of the preceding claims, **characterised in that** the carbon-based coating is of the type ta-C.

5. Sliding element according to at least one of the preceding claims, **characterised in that** the layer thickness of the coating is 0.5, preferably 10 to 30 µm.

6. Sliding element according to at least one of the preceding claims, **characterised in that** the carbon-based coating has an sp3 content of hybridised carbon atoms of at least 40 at%.

7. Sliding element according to at least one of the preceding claims, **characterised in that** the carbon-based coating has a modulus of elasticity of 180 to 260 GPa and/or a hardness of 1600 to 2800 HV0.02.

8. Sliding element according to at least one of the preceding claims, **characterised in that** the carbon-based coating contains oxygen and/or hydrogen with a content in each case of less than 0.5 at%.

9. Sliding element according to at least one of the preceding claims, **characterised in that** the carbon-based coating has an sp3/sp2 ratio of 0.3 to 1.2.

10. Sliding element according to at least one of the preceding claims, **characterised in that** a metal-containing bonding layer with chrome and/or titanium is provided between the carbon-based coating and a substrate.

11. Sliding element according to claim 10, **characterised in that** the bonding layer has a thickness of 0.05 to 1.0 µm.

12. Sliding element according to at least one of the preceding claims, **characterised in that** the carbon content in the carbon-based coating is more than 99% over the entire layer thickness.

13. Sliding element according to at least one of the preceding claims, **characterised in that** the sliding element is a piston ring made of cast iron or steel.

## Revendications

1. Elément coulissant, en particulier segment de piston, comprenant au moins une surface de roulement qui est pourvue d'un revêtement à base de carbone et présente au moins par sections une rugosité avec une valeur moyenne quadratique de l'augmentation de profil R_{Δq} selon la norme DIN EN ISO 4287 de 0,05, de préférence de 0,08 à 0,11, mieux encore jusqu'à 0,1.

2. Elément coulissant selon la revendication 1, **caractérisé en ce que** la valeur moyenne quadratique de l'augmentation de profil R_{Δq} de 0,05 à 0,1 se présente au moins dans la zone d'un bombement de l'élément coulissant.

3. Elément coulissant selon la revendication 1 ou 2, **caractérisé en ce que** la valeur moyenne quadratique de l'augmentation de profil R_{Δq} de 0,05 à 0,1 se présente dans la direction axiale sur 10 à 90 %, de préférence sur 25 à 75 % de la surface de roulement.

4. Elément coulissant selon au moins l'une quelconque des revendications précédentes, **caractérisé en ce que** le revêtement à base de carbone est du type ta-C.

5. Elément coulissant selon au moins l'une quelconque des revendications précédentes, **caractérisé en ce que** l'épaisseur de couche du revêtement atteint 0,5, de préférence 10 à 30 µm.

6. Elément coulissant selon au moins l'une quelconque des revendications précédentes, **caractérisé en ce que** le revêtement à base de carbone présente une fraction sp3 d'atomes de carbone hybridés d'au moins 40 % at.

7. Elément coulissant selon au moins l'une quelconque des revendications précédentes, **caractérisé en ce que** le revêtement à base de carbone présente un coefficient d'élasticité de 180 à 260 GPa et/ou une dureté de 1 600 à 2 800 HV 0,02.

8. Elément coulissant selon au moins l'une quelconque des revendications précédentes, **caractérisé en ce que** le revêtement à base de carbone présente de l'oxygène et/ou de l'hydrogène en fraction de respectivement moins de 0,5 % at.

9. Elément coulissant selon au moins l'une quelconque des revendications précédentes, **caractérisé en ce que** le revêtement à base de carbone présente un rapport sp3/sp2 de 0,3 à 1,2.

10. Elément coulissant selon au moins l'une quelconque des revendications précédentes, **caractérisé en ce qu'**il est prévu entre le revêtement à base de carbone et un substrat une couche adhésive métallique avec du chrome et/ou du titane.

11. Elément coulissant selon la revendication 10, **caractérisé en ce que** la couche adhésive présente une épaisseur de 0,05 à 1,0 µm.

12. Elément coulissant selon l'une quelconque des revendications précédentes, **caractérisé en ce que** la fraction de carbone dans le revêtement à base de carbone atteint plus de 99 % sur la totalité de l'épaisseur de couche.

13. Elément coulissant selon l'une quelconque des revendications précédentes, **caractérisé en ce que** l'élément coulissant est un segment de piston qui est constitué de fonte de fer ou d'acier.
